Europäisches Patentamt

European Patent Office

Office européen des brevets

(11) Publication number: **0 445 888 A2**

# EUROPEAN PATENT APPLICATION

(21) Application number: 91200462.9

(22) Date of filing: 05.03.91

(51) Int. Cl.⁵: **H01L 29/72**, H01L 29/08, H01L 29/06

(30) Priority: 08.03.90 IT 660690

(43) Date of publication of application:
11.09.91 Bulletin 91/37

(84) Designated Contracting States:
DE FR GB

(71) Applicant: CONSORZIO PER LA RICERCA
SULLA MICROELETTRONICA NEL
MEZZOGIORNO
Stradale Primosole, 50
I-95121 Catania (IT)

(72) Inventor: Ronsisvalle, Cesare
Via Argo 22
I-95126 Catania, CT (IT)

(74) Representative: Arena, Giovanni
Viale Certosa 135
I-20151 Milano (IT)

(54) IGBT semiconductor device with high reverse breakdown voltage and related manufaturing process.

(57) The high reverse breakdown voltage is obtained by modifying the arrangement of the anode junction so that on the edge thereof there can be applied a passivating layer and, over the latter, a field plate structure

Fig.5

# IGBT SEMICONDUCTOR DEVICE WITH HIGH REVERSE BREAKDOWN VOLTAGE AND RELATED MANUFACTURING PROCESS

The present invention relates to an MOS power device with conductivity modulation, otherwise known as Insulated Gate Bipolar Transistor (IGBT), having a high reverse breakdown voltage of the anode junction.

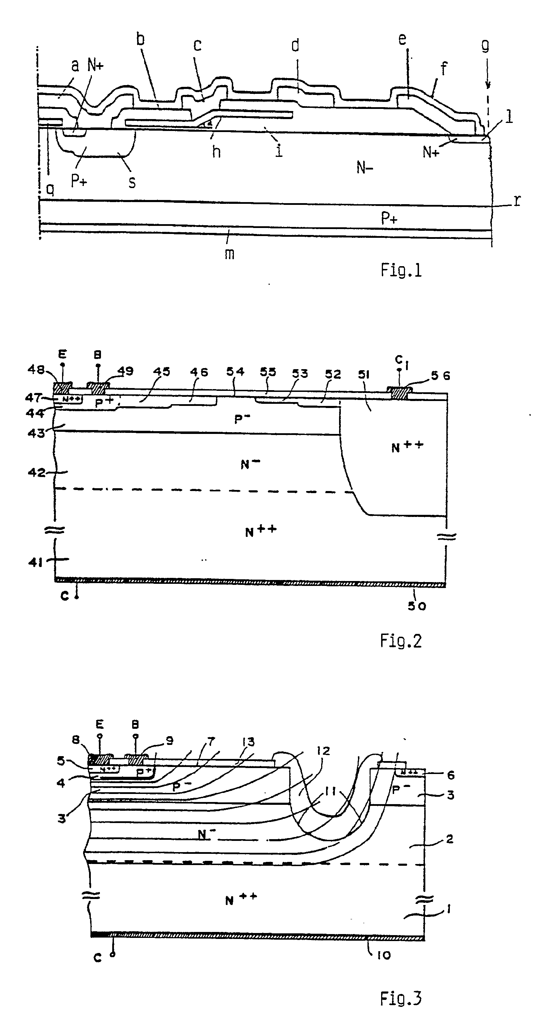

In IGBT devices obtained in accordance with the known art, of which FIG. 1 shows a structurally typical example, the reverse breakdown voltage of the anode junction is quite limited and in particular is lower than about 5V. The edge of the anode junction (junction between the substrate and the overlying epitaxial layer) is allocated on the side edge of the chip, after cutting of the latter. Consequently, since the edge of the junction is not in any way passivated and there is no structure (of the field plate, bevel etc. type) permitting lowering of the electric field value, breakdown voltage of this junction is extremely low.

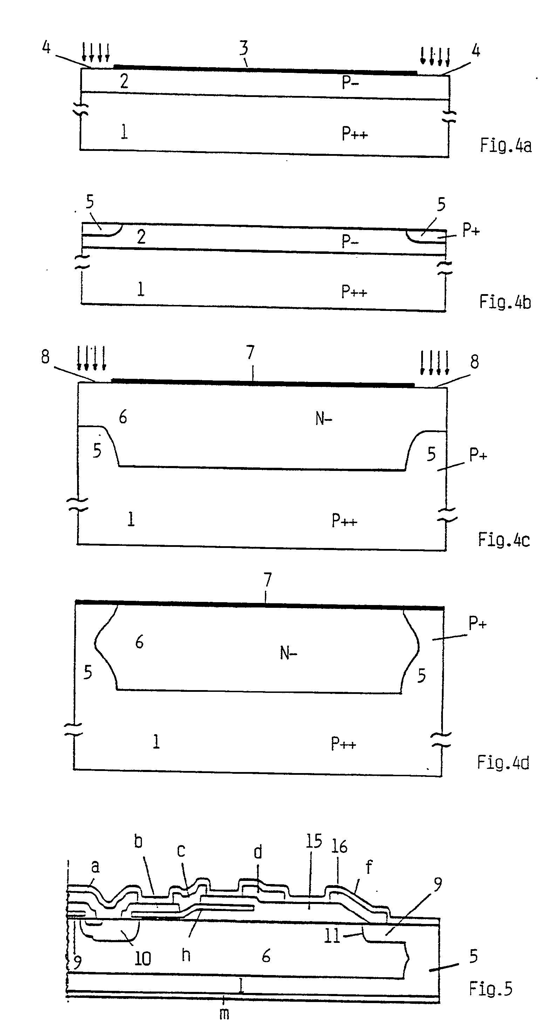

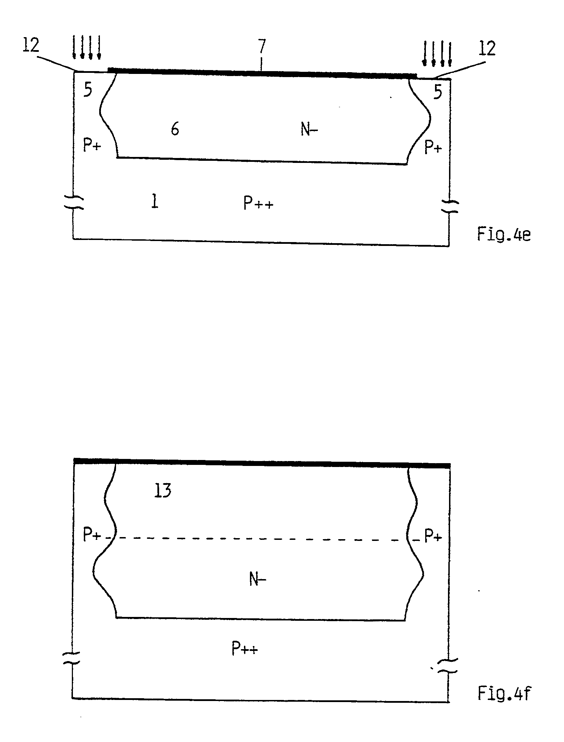

A solution for raising said voltage could be adoption of a passivation method similar to the one described in Italian patent No. 1,202,311 and in corresponding U.S. patent No. 4,805,004 with reference to the collector-base junction of a bipolar power transistor (see FIG. 4 of said patents, reproduced herein in FIG. 2). Said method employs a structure similar to the Mesa structure but, in place of the peripheral channel trenched chemically, calls for a deep diffusion (51) of the same type of conductivity as the substrate.

This type of structure cannot be used for high voltage IGBT devices with high thickness of the epitaxial layer, because realizing very deep diffused regions such as to reach the substrate would require extremely long diffusion time, even several days, so involving high costs. Another solution could be to obtain the device by Mesa technology so as to excavate a trench all around the chip sufficiently deep to uncover the anode junction and then passivate the junction surface with a layer of dielectric material, for example glass.

This solution presents analogies with the passivation system used for the collector-base junction of a Mesa transistor illustrated in FIG. 1 of the above mentioned patents, reproduced here in FIG. 3, but has the drawback that the materials used for passivation contain contaminants (e.g. moving NA+, K+, etc. ions in the case of glass) difficult to control, and which jeopardize the repeatability of the manufacturing process and the reliability of devices thus manufactured.

The object of the present invention is an IGBT device free from the above mentioned drawbacks, with high reverse breakdown voltage of the anode junction comparable to the BVdss (Breakdown Voltage drain-source shorted gate) of the device.

The device in accordance with the invention is realized in a chip comprising a substrate of a first type of conductivity and an overlying epitaxial layer having conductivity of the opposite type, whose junction constitutes the anode junction of the device, and is characterized by the presence along the periphery of the chip of a side insulation region of the top-bottom type formed in such a manner as to cause the anode junction to return upward laterally until it terminates in a surface zone of the chip covered in succession by a layer of $SiO_2$ and a metallic layer constituting the field-plate of the device.

Other inventive solutions are indicated below in the claims.

The characteristics of the invention will be more clearly understood from the following description of exemplificative non-restrictive embodiments, with reference to the accompanying drawings, in which:

FIG.1 shows an example of a known structure of an IGBT device,

FIGS.2 and 3 show two known passivation methods for the collector-base junction of a bipolar power transistor,

FIGS.4a-4d show a process embodying a device according to the invention,

FIGS.4e-4f show a variant of the process of FIGS. 4a-4d,

FIG.5 shows the structure of a device in accordance with the invention, and

FIGS.6a₀-6d show another example of an embodiment process for a device in accordance with the invention.

FIG.1 shows, as already mentioned, an example of a known structure of an IGBT device.

In said example the significance of the various parts is as follows:

a source metal

b intermediate layer of P-Vapox dielectric

c poly and gate feed metal

d field plate connected to the source metal

e Equipotential Ring (EQR) metal

f P-Vapox passivation layer

g chip cutting line

l channel stopper

q gate poly

s deep body

h poly field plate

i $SiO_2$ thermal oxide

r anode junction

m drain metal.

Said figure 1 shows how the edge of the anode junction "r" is on the side edge of the chip after cutting the same.

An embodiment process for an N channel MOS device in accordance with the invention is described in FIGS. 4a-4d. It calls for the following phases in sequence.

1. Epitaxial growth, on a substrate 1 of P++ monocrystalline silicon, of a thin (10μm) layer 2 of silicon with the same type of conductivity as the substrate but with much higher resistivity (FIG.4a).

2. Thermal oxidation of the silicon (see $SiO_2$ layer 3 in FIG.4a shown with side parts removed by the photoetching covered in phase 3).

3. Photoetching for removal of oxide along a side frame 4 running all around the chip and subsequent implantation of boron ($2 \cdot 10^{14}$ atoms/cm$^2$ with implantation energy of 80 KeV) at the frame (FIG. 4a).

4. Diffusion of implanted boron with resulting formation of the regions 5 and subsequent removal of the surface oxide (FIG. 4b).

5. New epitaxial growth of a layer 6 of phosphorous doped silicon (N-) the resistivity and thickness of which are determined by the voltage BVdss of the device it is desired to obtain (FIG. 4c). During this phase the outdiffusion of the boron of the substrate 1 equalizes the minor doping of epitaxial layer 2 and then causes it to disappear; in addition, during said growth phase the side regions 5 where the boron was implanted and diffused also diffuse upward (FIG. 4c).

6. Thermal oxidation of the silicon (layer 7 of $SiO_2$ in FIG. 4c).

7. Photoetching with subsequent implantation of boron (with quantities of $6 \cdot 10^{15}$ atoms/cm$^2$ and implantation energy of 80 KeB) in a frame 8 placed in perfect correspondence with the preceding frame 4 (FIG. 4c).

8. Oxidizing diffusion of the implanted boron. At the end of this phase the regions where the boron was implanted diffuse so as to join with the underlying regions 5 giving rise to the so-called top-bottom insulation (FIG. 4d).

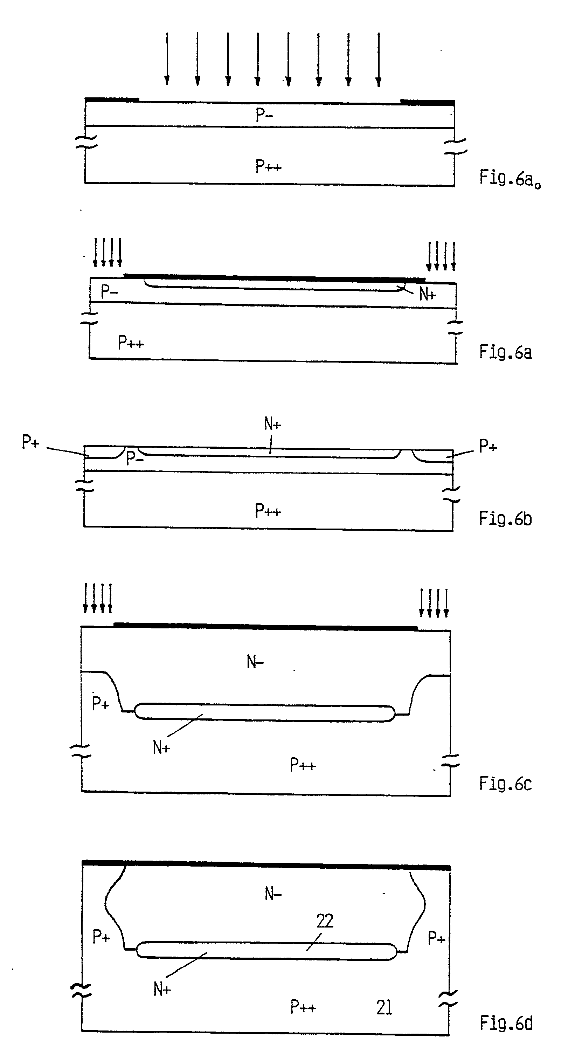

9. All of the processes related to the manufacture of a power MOS in accordance with the known art follow (see FIG. 5 in which the meaning of the letters is the same as in FIG. 1). The power MOS is obtained inside the two P+ side pockets 5 of FIG. 4d. In particular, at the edges of the power MOS structure in accordance with the invention the P+ outer ring 9, which is obtained simultaneously with the P+ deep body formation process, connects with the side pockets 5 described above. Therefore, as shown in FIG. 5, the anode junction 11 ends on the upper surface of the chip under the thick layer 15 of silicon oxide $SiO_2$.

At the end of all the thermal processes there is obtained in the zones where the boron was implanted and diffused (top-bottom insulation pockets 5) a dopant concentration much higher than the concentration of the epitaxial layer 6. This is necessary to create also at the edge of the chip the same type of junction as the substrate, such that the depletion zones extend almost exclusively in the less doped N- epitaxial layer.

The process described above permits obtaining devices with reverse breakdown voltage of approximately 600 V. If it is desired to obtain devices with higher reverse voltage (up to 1200 V), the operational sequence described above should be modified by introducing between phases 8 and 9 the following processes: starting from FIG. 4d there is performed a new photoetching the same as that of FIG. 4c, then follows boron implantation at the frame 12 (FIG. 4e), a nonoxidizing diffusion, removal of the oxide layer and a new epitaxial growth 13 followed by an oxidation (FIG. 4f).

If it is desired to manufacture devices with an N+ buffer layer and hence stronger, i.e. with higher latchup current (see for example the device described in European Patent Application No. 89200717.0), the present invention permits obtaining devices with much lower reverse voltages (on the order of 50 V) since the anode junction shown in FIG. 5 would be made up of two highly doped regions: the P++ type substrate 21 and the N+ type buffer layer 22 (see FIG. 6d of the following description). The critical electrical field and hence the breakdown voltage, which is a function of the dopant concentration, would fall considerably.

In this case the manufacturing process is modified by inserting after phase 2 (thermal oxidation 3 of the silicon of FIG. 4a) a photoetching and subsequently an implantation and oxidizing diffusion of antimony or arsenic (FIG. 6a$_0$) and then the sequence of FIGS. 4a, 4b, 4c and 4d, reproduced in FIGS. 6a, 6b, 6c and 6d.

In all three cases the anode junction at the edges of the chip turns upward, appears at the surface and the device is completed up to obtaining substantially the structure of FIG. 5. In particular a layer of silicon oxide 15 is thermally deposited on the edge of the junction and subsequently there is deposited thereon a film 16 of aluminium which, on the outside, contacts the silicon in the region of the P+ ring 9 or in the P+ top-bottom pocket 5, while it lies over the oxide 15 on the inside.

This aluminium film acts as a field plate, i.e. it widens the electrical field lines inside the N- epitaxial layer.

FIG. 5 also shows how the finished device allows embodiment of a field plate which inserts perfectly in the edge structure of the IGBT device.

It is clear that the solution indicated above with reference to an N channel IGBT device can be used to manufacture a P channel IGBT in the three versions described above.

## Claims

1. IGBT semiconductor device embodied in a chip comprising a substrate of a first type of conductivity and an overlying epitaxial layer having conductivity of the opposite type whose junction constitutes the anode junction of the device, characterized by the presence along the periphery of the chip of a top-bottom side insulation region (5) formed in such a manner as to cause the anode junction (11) to return upward laterally until it terminates in a surface zone of the chip covered in succession by a layer of $SiO_2$ (15) and a metallic layer constituting the field-plate of the device.

2. IGBT semiconductor device in accordance with claim 1 characterized in that the side insulation region (5) widens at the top in the form of a ring (9).

3. Manufacturing process for an IGBT semiconductor device embodied in a chip comprising a substrate having a first type of conductivity and an overlying epitaxial layer having conductivity of the opposite type, whose junction constitutes the anode junction of the device, and comprising also along the periphery of the chip a top-bottom side insulation region formed in such a manner as to cause the anode junction (11) to rise laterally until it terminates in a surface zone of the chip covered in succession by an $SiO_2$ layer (15) and a metallic layer (16) constituting the field-plate of the device, characterized in that there are provided in sequence the following steps:

   1. Epitaxial growing on the substrate (1) of a thin layer (2) having the same type of conductivity as the substrate (1) but much higher resistivity;

   2. Thermal oxidizing of the surface of the layer (2);

   3. Photoetching to remove the oxide formed on the surface of the layer (2) along a side frame (4) running all around the chip and subsequent implanting of dopant of the first type of conductivity at said frame (4);

   4. Diffusing said implanted dopant with resulting formation of side regions (5) followed by removal of the surface oxide;

   5. New epitaxial growing of a layer (6) of conductivity of a type opposite to that of the first with simultaneous outdiffusion of the dopant of the substrate (1) such as to equalize the epitaxial layer (2) and then cause it to disappear, and simultaneous upward diffusion of the side regions (5);

   6. Surface thermal oxidizing of the layer (6);

   7. Photoetching to remove the oxide formed on the surface of the layer (6) along a side frame (8) running all around the chip and placed in perfect correspondence with the above frame (4) and subsequent implantation of dopant of the first type of conductivity at said frame (8);

   8. Oxidizing diffusion of the dopant recently implanted such as to cause diffusion of the implantation regions until it joins with the underlying regions (5) thus giving rise to a single top-bottom insulation region (5).

4. Manufacturing process for an IGBT semiconductor device in accordance with claim 3 characterized in that the IGBT device is obtained in the side insulation region (5) in accordance with the known art and in that simultaneously with the formation process of a deep body (10) there is obtained at the edges of the IGBT structure an annular region (9), presenting the first type of conductivity, which reunites with the side insulation region (5).

5. Manufacturing process for an IGBT semiconductor device in accordance with claim 3 characterized in that the substrate (1) is obtained with P++ monocrystalline silicon, the layer (2) is obtained with P- silicon having higher resistivity, and in that during said step 3 an implantation of a quantity of $2 \cdot 10^{14}$ atoms/cm$^2$ of boron is performed, with implantation energy of 80 KeV at the frame (4).

6. Manufacturing process for an IGBT semiconductor device in accordance with claim 5 characterized in that said epitaxial growth of the layer (6) relates to a layer of phosphorous doped silicon (N-) the resistivity and thickness of which are determined by the voltage BVdss of the device it is desired to obtain.

7. Manufacturing process for an IGBT semiconductor device in accordance with claim 6 characterized in that during the above mentioned step 7 there is performed at the frame (8) implantation of a quantity of $6 \cdot 10^{15}$ atoms/cm$^2$ of boron with implantation energy of 80 KeV.

8. Manufacturing process for an IGBT semiconductor device in accordance with claim 3 characterized in that after said step 8 there follow the following other steps:

   9. new photoetching to remove the oxide formed on the surface of the layer (6), along a side frame (12) running all around the chip and placed in perfect correspondence with the above frame (8), and subsequent implantation of dopant of the first type of conductivity at the frame (12);

10. nonoxidizing diffusing of the implanted dopant;

11. removing the oxide layer present on the surface of the layer (6) and growing a new epitaxial layer (13) followed by surface oxidizing.

Fig.1

Fig.2

Fig.3

Fig.4a

Fig.4b

Fig.4c

Fig.4d

Fig.5

12 ↓↓↓↓ 7 ↓↓↓↓ 12

5 5

6 N–

P+ P+

1 P++

Fig.4e

13

P+ P+

N–

P++

Fig.4f

Fig.6a₀

Fig.6a

Fig.6b

Fig.6c

Fig.6d